Europäisches Patentamt

European Patent Office

Office européen des brevets

(11) Publication number: **0 354 722**
**A2**

(12) # EUROPEAN PATENT APPLICATION

(21) Application number: 89307878.2

(51) Int. Cl.⁴: **H01L 23/433 , H01L 23/40**

(22) Date of filing: 02.08.89

(30) Priority: 08.08.88 JP 195988/88

(43) Date of publication of application:
**14.02.90 Bulletin 90/07**

(84) Designated Contracting States:
**DE FR GB**

(71) Applicant: **HITACHI, LTD.**
**6, Kanda Surugadai 4-chome Chiyoda-ku**
**Tokyo(JP)**

(72) Inventor: **Morihara, Atsushi**
**9-2-305, Aoba-cho**
**Hitachi-shi Ibaraki-ken(JP)**
Inventor: **Naganuma, Yoshio**
**2-20-1, Mizuki-cho**
**Hitachi-shi Ibaraki-ken(JP)**
Inventor: **Yokoyama, Hiroshi**
**4-11-7, Ohse-cho**
**Hitachi-shi Ibaraki-ken(JP)**
Inventor: **Kawamura, Keizo**
**3602 Shimoinayoshi Chiyoda-mura**
**Niihari-gun Ibaraki-ken(JP)**
Inventor: **Miyamoto, Mitsuo**
**438-3, Tokawa**
**Hadano-shi Kanagawa-ken(JP)**

(74) Representative: **Paget, Hugh Charles Edward**
**et al**
**MEWBURN ELLIS & CO. 2/3 Cursitor Street**
**London EC4A 1BQ(GB)**

(54) **Heat transfer system especially for cooling semiconductor devices.**

(57) Heat transfer system particularly for cooling semiconductor devices, has a first body (10) having a planar first surface (15) and a second body having a second surface (14). A heat conducting contact body (4) contacts both said first and second surfaces to transfer heat, and has a planar third surface (6) contacting said first surface (15) face-to-face and a fourth surface (5) contacting said second surface (14). A spring 8 acts upon the contact body (4) in a predetermined direction to urge the contact body in a wedge-type action against both said first surface (15) and said second surface (14). The second surface (14) is a planar surface at an angle α to the first surface (15) and the fourth surface (5) is a convexly curved surface curving in one plane, so that the second and fourth surfaces make line contact. The contact body (4) is free to move so as to maintain said face-to-face contact and said line contact, in order to accommodate varying relative positioning of said first and second bodies. The direction of action of the spring (8) is at an angle β to the first surface (15) given by $0 < \beta < (\alpha + 5)$, wherein α and β are expressed in degrees.

## HEAT TRANSFER SYSTEM ESPECIALLY FOR COOLING SEMICONDUCTOR DEVICES

This invention relates to a heat transfer system and to apparatus comprising at least one heat generating device and a cooling system for that device. The heat generating device may be a semiconductor device or a superconducting device. The invention is especially applicable to cooling of semiconductor devices, particularly where a plurality of such devices are mounted on a common base.

Since large scale computers require high processing speeds, integrated circuit technology has recently produced highly dense semiconductor devices. The heat generated from such a device has increased, and consequently the cooling of such integrated circuit devices has become a serious problem.

JP-A-87106699 shows a system for cooling semiconductor chips using spring biased wedges. The wedges each have planar wedge faces which engage respectively an angled face on bodies mounted on the chip and a planar surface on a cooling body. While the contact of these planar faces can provide good heat transmission, this system has no possibility of accommodating chips of varying inclination. Inevitably, where a number of chips are mounted on a common base, the inclination of their top surface varies. Although the manufacturers attempt to reduce this variation, it can amount to 1 to $2°$. Unless steps are taken to accommodate this variation, cooling efficiency is greatly reduced.

JP-A-8615353 illustrates one cooling system designed to accommodate varying chip inclination. A piston-like member having a part spherical end face which contacts the chip top surface is located in a cylindrical bore in the cooling body and is urged against the chip by a spring. Between the piston body and the walls of the cylindrical bore is a gap filled with helium, which is a highly thermally conductive gas. While the use of the spherical surface and the spring accommodates inclination and height of the chip top surface, this arrangement suffers from the defects that there is point contact between the piston and the chip surface and that the helium gas provides insufficient heat transfer from the piston to the cooling body.

JP-A-8391665 discloses a similar combination of piston and cylindrical bore.

JP-A-85126853 discloses another piston-cylinder arrangement in which the piston and cylinder have an interlocking fin structure to reduce the heat resistance of the helium gas as much as possible. However, this structure is complex and does not remove the defects of the system.

None of these systems is able to provide adequate cooling for the highly dense integrated circuits required for large scale computers.

EP-A-288183 (corresponding to USSN 07/178650) was published after the priority date claimed in the present application and discloses a cooling arrangement for semiconductor chips which can accommodate varying inclination of the chips while providing a high level of cooling. For each chip, a number of wedge-like members provide cooling paths between the chip surface and inclined surfaces of the cooling body. The planar face of the wedge contacts the planar face of the chip, giving good thermal contact, while a curved face of the wedge makes line contact with the inclined face of the cooling body. The wedges are urged into position by springs. Since the wedges can slide on the chip surface, and can also turn about an axis perpendicular to the chip surface, they can position themselves so as to maintain both the face-to-face contact with the chip and the line contact with the cooling body. While this heat transfer system provides considerably improvements over the prior art, the present inventors have now made some further improvements, which are the subject of the present application.

The object of the invention is thus to provide improvement in the heat transfer system disclosed in EP-A-288183 and USSN 07/1à78650, particularly in its application to cooling of semiconductor devices.

In one aspect, the invention provides a heat transfer system comprising a first body having a planar first surface and a second body having a second surface spaced from said first surface. A contact body of heat conductive material contacts both said first and second surfaces to transfer heat by conduction from one of said first and second bodies to the other. The contact body has a planar third surface contacting said first surface face-to-face and a fourth surface contacting said second surface.

Means e.g. a spring, provide a force acting resiliently upon said contact body in a predetermined direction so as to urge said contact body in a wedge-type action against both said first surface and said second surface.

One of said second and said fourth surfaces is a planar surface at an angle $\alpha$ to said first surface and the other thereof is a convexly curved surface curving in one plane. The second surface and the fourth surface make line contact. The contact body is free to move so as to maintain the face-to-face contact and the line contact, in order to accommodate varying relative positioning of said first and second bodies.

The predetermined direction of action of the force-providing means is at an angle $\beta$ to said first surface given by $0 < \beta < (\alpha + 5)$, wherein $\alpha$ and $\beta$ are expressed in degrees.

In another aspect, the invention provides a semiconductor or superconductor device having a cooling system including the heat transfer system of the invention.

In yet another aspect, the invention provides apparatus having a plurality of semiconductor devices individually cooled by the heat transfer system.

In brief, the invention provides an improved relationship between the wedge angle of the wedge-type heat transfer device and the direction of action of the resilient means, e.g. a spring, which provides the force maintaining the wedge in position. As indicated above, these angles are $\alpha$ and $\beta$, and should satisfy the relationship $0 < \beta < (\alpha + 5)$.

Preferably $\alpha$ lies between 20 and 70°, more preferably 30 and 45°. Preferably $\beta$ is less than 2° larger than $\alpha$ and preferably $\beta$ also is not less than half $\alpha$.

In one particularly advantageous embodiment of the invention, the resilient means, e.g. a mechanical spring attaches the wedge-like body (contact body) to the cooling body so that the wedge-like body is not dislodged from its position by gravity or shock. This removes the danger that the wedge-like body will fall out of its position and collide with another such body or with a semiconductor device.

Another significant advantage which the present invention can provide is that the whole heat dissipation surface of the semiconductor device is contacted by a single heat transfer wedge-like body. This ensures that all areas of the semiconductor device are cooled, so avoiding local overheating of the device.

It is also an advantage of the present invention that the resilient force providing means, e.g. a spring, together with the surface of the semiconductor device and the cooling body, locate the wedge-like body (contact body) in a single unique position by virtue of the geometry of the device.

Preferred embodiments of the invention will now be described by of non-limitative example with reference to the accompanying drawings, in which:

Fig. 1 is a partial cross-sectional view of a semiconductor module embodying the heat transfer system of the present invention;

Fig. 2 is a diagrammatic exploded view of the essential parts of the heat transfer system shown in Fig. 1;

Fig. 3 is a cutaway general view of an apparatus including a large number of semiconductor chips cooled by heat transfer systems of the invention;

Fig. 4 is a cross-sectional view of a semiconductor module having an alternative heat transfer system of the present invention;

Fig. 5 is a cross-sectional view of a semiconductor module having yet another heat transfer system embodying the invention.

Fig. 6 is a diagrammatic cross-sectional view of an embodiment in which the invention is applied to semiconductor packages; and

Fig. 7 is a diagrammatic view of a cooling system for a computer including modules embodying present invention.

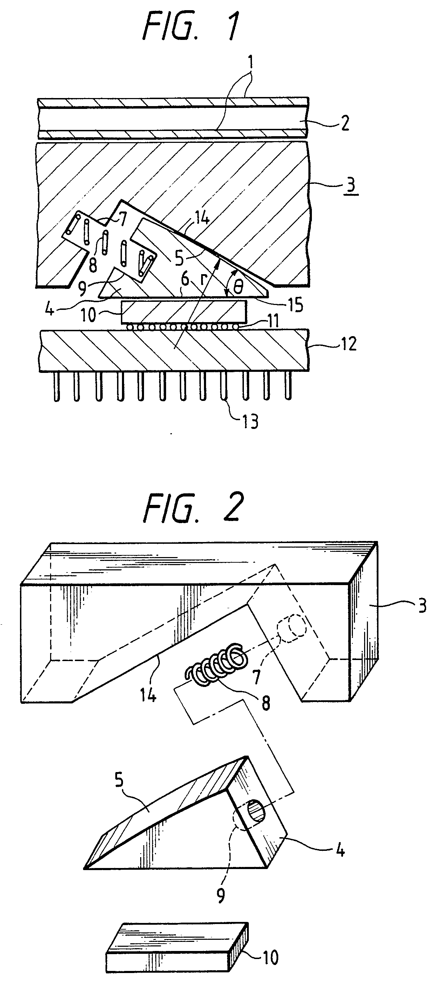

Referring first to Fig. 1, the semiconductor module here shown has a semiconductor chip 10 mounted by a plurality of ball type solder connections 11 on a multilayer substrate 12 which has connection pins 13 projecting from its lower surface. Above the chip 10 is a cooling arrangement, comprising a heat conducting housing block 3 in good thermal contact at its top surface with a pipe 1 in which coolant fluid 2 flows.

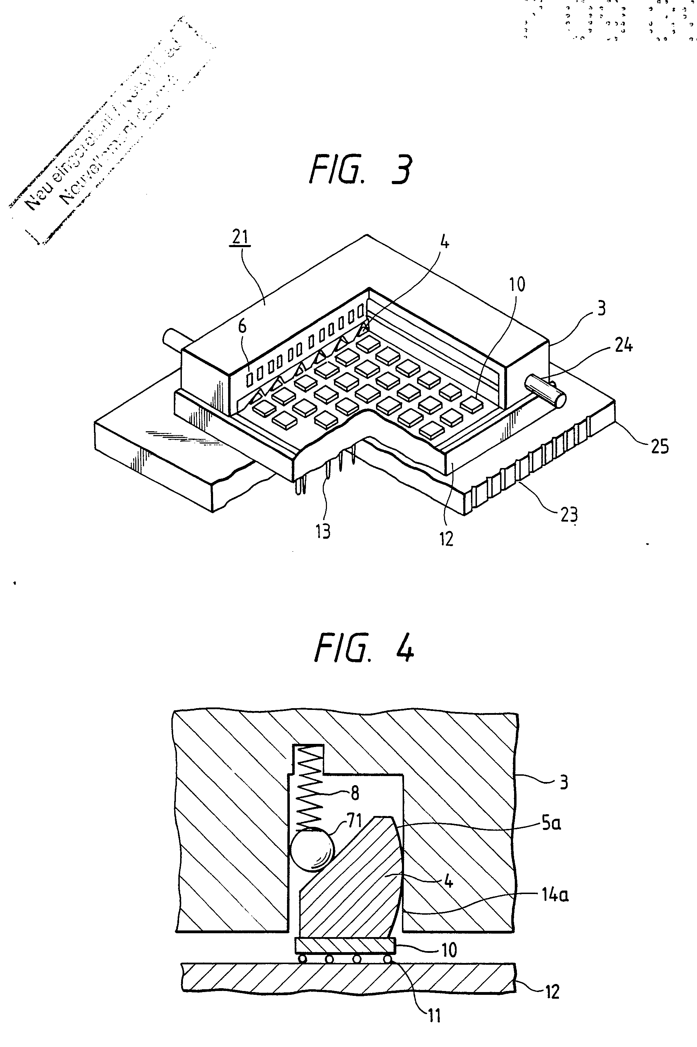

As shown by Fig. 3 a large number of chips 10 are mounted on the same board 12 and cooled by the same block 3 which also forms a housing hermetically enclosing the chips.

Fig. 1 shows a heat transfer system of the invention consisting of a contact body in the form of a wedge 4 connected to the block 3 by a mechanical compression spring 8 whose ends are housed in recesses 7,9 respectively in the block 3 and the wedge 4. The spring 8 provides a force urging the wedge 4 in a direction determined by the axial direction of the spring at the wedge 4.

The wedge 4 provides a thermal connection between the planar top surface 15 of the chip 10 and the opposed planar inclined surface 14 of the block 3. The wedge 4 is thus accommodated in a recess or concavity of the block 3.

Fig. 3 shows that the housing block 3 has plurality of such concavities each accommodating a plurality of the wedges 4.

The cylindrical recesses 7 and 9 accommodating the spring 8 are aligned, but the spring 8 permits movement of the block 4 not only parallel to the plane of the top surface 15 of the chip but also in a twisting motion on that top surface.

The wedge 4 has wedge surfaces 5 and 6. The lower surface 6 is planar and makes face-to-face contact with the planar top face 15 of the chip 10. This ensures good thermal contact. The wedge surface 6 is larger than the top surface 15 of the chip, so that whole surface of the chip is cooled by the wedge 4 and no excessively hot areas of the chip exist. The other wedge surface 5 is a cylindrically curved surface of radius r, which makes line contact with the planar surface 14 of the block 3 which thus contacts the surface 5 tangentially.

The surface 5 is thus curved in a single plane which can be taken as the plane corresponding to the section plane of Fig. 1, though as mentioned the wedge 4 is free to twist on the surface of the chip, about an axis perpendicular to the surface 15 as well as to slide on the chip. In practice the radius of curvature of the cylindrical surface 5 is larger than indicated by the arrow r in Fig. 1, and is considerably larger than the dimensions of the surface 15. To give some indication of dimensions, a typical chip 10 has a square top surface 15 of side length 10 mm. The preferred value of r for such chip is 200 mm, a typical range for r being 100 to 300 mm. A value of r of 200 mm can accommodate variation of inclination of a chip surface 15 of about 1.5°.

The angle $\alpha$ between the plane surfaces 14 and 15 is about 30° in the embodiment of Fig. 1. At the ideal location of the wedge 4, this angle $\alpha$ is equal to the angle $\theta$ which is the angle between the face 6 and the tangent at the mid-point of the side 5. Of course, in practice if the chip is inclined, $\alpha$ deviates from $\theta$.

Because the wedge 4 is able to move freely on the surface 15, under the action of the spring 8 it assumes the correct position so as to maintain both the face-to-face contact between the surfaces 6 and 15 and the line contact (tangential contact) between the surfaces 5 and 14. Thus cooling of the chip 10 proceeds by way of the wedge 4 though the line contact to the block 3 and to the coolant 2. There is never less than line contact at the engaging surfaces 5,14 in this heat flow path, whatever the inclination and height of the chip 10 within certain ranges. The angle $\alpha$, the size of the wedge 4 and the radius of curvature r are chosen appropriately in relation to the expected range of inclination and heights of the chips 10.

The direction of application of force by the spring 8 on the block 4 is approximately parallel to the surface 14. According to the invention, this direction of application makes an angle $\beta$ to the surface 15 which is not more than 5°, preferably not more than 2°, larger than $\alpha$. $\beta$ is greater than 0°, i.e. the spring action is not parallel to the surface 15, and preferably $\beta$ is not less han half $\alpha$. Appropriate choice of direction of action of the spring 8 ensures that the wedge 4 remains in correct contact with both the surfaces 15 and 14 as described above. If $\beta$ is too large, there is excessive friction between the surfaces 15 and 6, and if $\beta$ is 0 there may not be sufficient force on the surface 15 or the wedge 4 may not align itself correctly to maintain the desired face-to-face contact and line contact. Preferably the line of action of the force applied by the spring on the wedge 4 intersects approximately the centre of the surface 15.

Because the semiconductor device is assembled in dust free conditions, good sliding action is achieved at the surface 15.

Following this explanation of Fig. 1, it will be appreciated that the principle of the invention i.e. face-to-face contact at one side and line contact at the other side of a wedge member 4, can be carried out in various different ways, For example, the surface 5 of the wedge may be planar, as well as the surface 6, while the surface 14 of the block 3 is convexly curved. Such an arrangement operates in the same way, but it less convenient to manufacture, since each wedge 4 can easily be ground to the required shape, whereas it is more difficult to grind the recessed surface of the block 3.

Alternatively the face-to-face contact may be between the surfaces 5 and 14, and the line contact between the surfaces 6 and 15. However, when cooling a semiconductor chip, it is preferable for the whole of the surface 15 to make face-to-face contact with the surface 6 to achieve uniform cooling of the chip.

The surface 5 has cylindrical curvature, i.e. curvature in a single plane only. Alternatively, the surface may have curvature of parabolic section or approximating to a parabolic section, in both cases this being curvature in one plane only. This may be advantageous compared with a cylindrical curvature, because when a chip is inclined from the ideal position, heat transfer efficiency does not decrease so much, for geometrical reasons connected with the size of the gaps between the surface 5 and 14.

The spring 8 attaches the wedge 4 to the block 3, which is advantageous since it avoids the risk that the wedge 4 may become detached from its position between the chip and the surface 14 and fall onto another wedge 4 or another chip 10, which might seriously damage the apparatus. Such dislodgement of the wedge 4 might occur due to gravity, if the face of the chip 15 is vertical in the assembled condition, or might be due to a shock.

From the geometry of the device, it arises that there is a single unique position of the wedge 4 for each relative position of the chip 10 and the surface 14.

As many as several hundred wirings under the chip 10 are bonded to the ceramic multilayered substrate 12 by the solder balls 11. In manufacture, also, the surfaces of the chips 10 and the wedges 4 are polished or lapped to minimize friction and to achieve high thermal contact.

The choice of the angle $\alpha$ mentioned above is inportant for control of the movement of the wedge 4 under the influence of the spring 8. If the angle $\alpha$ is increased, the area of the surface 5 providing conduction is also increased, but the distance between the chip surface 15 and the cooling surface 14 of the block also increases, thereby providing a longer conduction path. Preferred values for the angle α are given above.

Fig. 3 shows the cooling system of Fig. 1 applied to semiconductor apparatus having a large number of chips 10. The chips 10 are mounted in common on a board 12, and the pins 13 project into holes 23 in a support board 25 in conventional manner. On the board 12 is also mounted the block 3 providing a housing which, with the board 12, hermetically encloses the chips 10 and the wedges 4. The cooling passages in the housing block 3 are indicated at 6 and the top surface of the housing at 21. In practice, the housing may be in several parts sealed together and with appropriate thermal contact ensured. A cooling liquid inlet 24 and outlet are indicated.

In the space within the housing, a helium gas atmosphere is present. Helium is a highly thermally conductive gas, and increases the heat conduction from the chips to the block 3, particularly at the narrow gaps between the surfaces 5 and 14 of the wedge 4 and the block 3. The coolant is water. Warm water may be used, to avoid condensation.

The housing 3 may be made of metal or ceramic material, for example Cu, Cu-Mo alloy, Al, SiC or AlN. The wedge 4 is preferably a ceramic material, in order to avoid the danger that a particle detaching from it causes a short circuit of the semiconductor wiring. Suitable ceramics are SiC and AlN. The multilayer wiring substrate 12 may be a ceramic material, e.g. alumina, mullite, silica, AlN or silicon nitride.

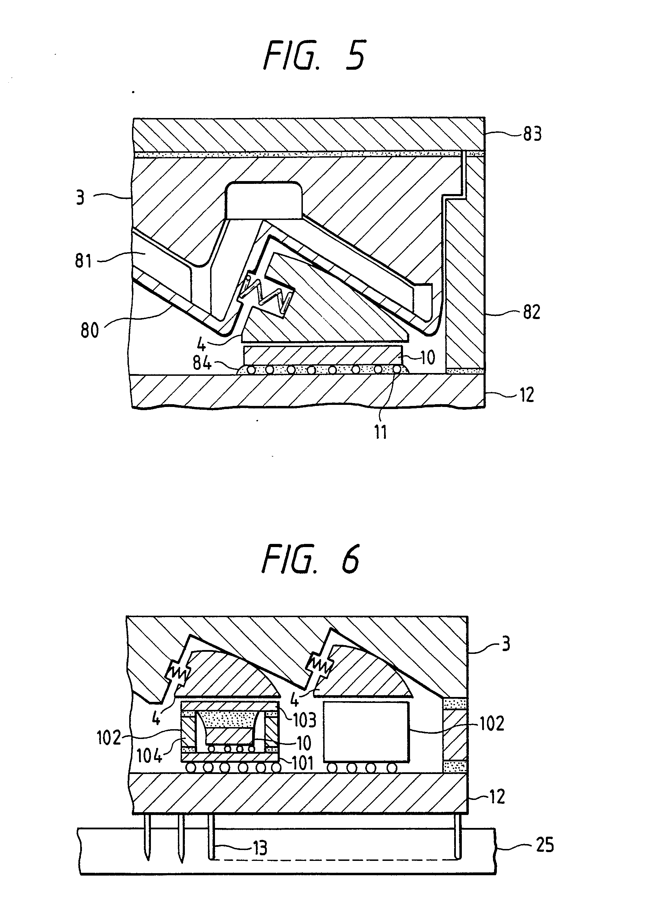

In Fig. 4, the same reference numerals are used as in Figs. 1 and 2 for corresponding parts. In the embodiment of Fig. 4, which operates on the same principle as the embodiment of Figs. 1 and 2, the wedge 4 has a planar bottom surface engaging the planar top surface of the chip 10. The wedge 4 is of square cross-section in a plane parallel to the top surface of the chip 10 except that it has at one side a surface 5a curving cylindrically in the plane of Fig. 4 and making line contact with a surface 14a of a recess in the block 3. The surface 14a is approximately perpendicular to the top surface of the chip 10. The force resiliently urging the wedge 4 into face to face contact with the chip 10 and line contact with the block 3 is provided by a spring 8 which has one end within a recess in the block 3 and its other end engaging a ball 71. The ball 71 tangentially contacts a flat inclined surface of the wedge 4. In this embodiment the angle β is about 45°. The angle α is about 90°. While in this embodiment the wedge 4 is not attached to the block 3 by spring 8, it is possible to design the block 3 so that coolant flows within it close to the line contact.

Fig. 5 shows an embodiment similar to that in Fig. 1 except that here the coolant passage is at the lower side of the housing block 3 and is closed by the thin metal sheet 80 carrying baffles 81 which control the flow direction of the coolant. Coolant flow is in the direction perpendicular to the plane of Fig. 5. The metal sheet 80 is appropriately sealed to the block 3. Other parts of the housing are provided as shown by plates 82 and 83 sealed to each other, to the block 3 and board 12. The sealant is solder. It can be seen that the heat transfer path from the chip 10 to the coolant fluid is very short. In this embodiment also, the chip 10 is also connected to the board 12 by thermally conductive resin which includes inorganic filler particles such as alumina or silica.

The embodiment of Fig. 6 shows the heat transfer system of Fig. 1 applied to a semiconductor package 102, in which the spring-biased movable wedge member 4 does not contact the chip surface directly but makes face-to-face contact with the planar top surface of the package 102 which is in direct thermal connection with the chip 10 itself. The arrangement and operation of the heat transfer system is the same as in Fig. 1 and will not be described again. The chip 10 is mounted in a microchip carrier using CCB connections (controlled collapse of bonding). The carrier comprises a wiring substrate 101 on which the chip 10 is mounted by solder balls, a cap 103 having a planar top surface engaged by the wedge 4 connected to the whole of the top surface of the chip 10 by a solder layer, and a side wall 104. The side wall 104 is sealed to the substrate 101 and the cap 103 by solder, so that the chip 10 is hermetically enclosed. The chip 10 is sealed in with an inert gas such as argon or helium.

The cap 103 should be made a highly thermally conductive compound, preferably a ceramic such as AlN or SiC, which preferably has a thermal conductivity of 200 W/m.K and a thermal expansion coefficient of $3.5 \times 10^{-6}$ $K^{-1}$. The substrate 101 is also of ceramic and is a single or multilayer circuit substrate with through holes. For this substrate 101, mullite having an intermediate thermal expansion coefficient is suitable. The side wall 104 is also made a ceramic e.g. mullite.

As Fig. 6 shows, a plurality of the semiconductor packages 102 are installed on a single multilayer wiring circuit substrate 12 and surrounded by a non-oxidizing gas. The encapsulating package 102 provides particularly safe operation of the chip. As in other embodiments, the circuit board 12 is connected to a printed wiring substrate 25 by pins 13.

Good cooling of the chip 10 can be achieved in this embodiment. The heat resistance between the chip and the cooling pipe in the block 3 can be reduced to below 2°C/W (W is the power supplied to the chip in watts). The average temperature of the chip can be as low as 60 to 70°C, and its maximum temperature can be kept below 85 C. Cooling water at a temperature slightly above ambient temperature is used, to avoid condensation. The package shown in Fig. 6 can of course be applied in the embodiments of Figs. 4 and 5.

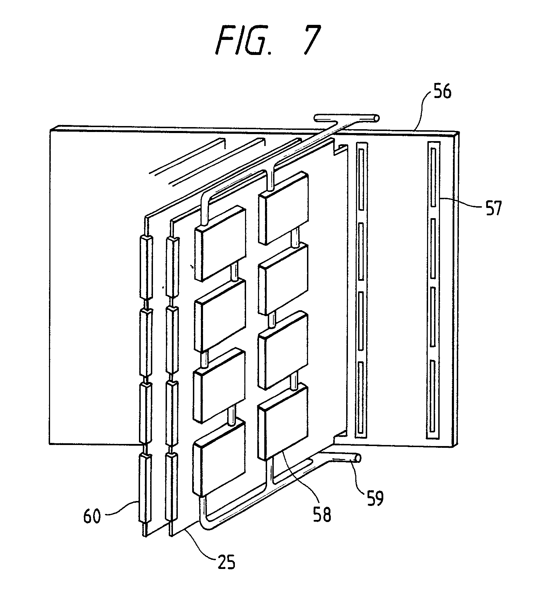

Fig. 7 is a diagrammatic view of part of a computer structure using the cooling system of the invention. LSI multichip module packages 58, each as shown in Fig. 3, are installed on the multilayer printed substrate 25 by pins 13 as indicated in Fig. 3. At one edge of the board 25, connection terminals 60 connect to outside terminals, and at the other edge connection is made with multiple cable connectors 57 on a backboard 56, to form a three-dimensional structure. Coolant flows to the modules 58 through the piping 59. A compact construction, providing highly efficient cooling performance, can be achieved.

From the description above it will be apparent that the invention provides various advantages. A large number of chips can be simultaneously cooled, while interference between neighbouring cooling devices can be avoided. The structure of the heat transfer system is simple, reducing cost. The wedge of the heat transfer system adapts itself always to the inclination of the chip surface, so that each chip is properly cooled. The heat transfer system is not restricted to any orientation in space, and the chips can be mounted vertically, e.g. as shown in Fig. 7. Since the cooling structure is simplified, the distance between the chips can be reduced, allowing greater compactness and higher speed of operation of the computer.

The wedge 4 and the block 3 can be formed of any suitable thermally conductive material, e.g. metal, cermet or ceramic. A thermal conductivity of at least 200 W/m.K is desirable. A ceramic compound which is a good electrical insulator, such AlN or SiC is preferred. As the means providing a resilient force on the wedge 4, a spring, particularly a coil or leaf spring made of metal or ceramic is preferred.

To give one example, with a wedge 4 of angle $\theta$ of 30° in the arrangement as shown in Fig. 1, we use a stainless steel coil spring of diameter 1.8 mm and spring force coefficient of 20 g/mm. The arrangement should be such that the force applied to the chip surface is less than 100 g/cm². 

If highly thermally conductive helium gas is not employed around the chip and heat transfer system, thermally conductive grease may instead be provided at the gaps between the surfaces 5 and 14, to increase the thermal conduction.

While it is preferred in the invention that the means for providing resilient force acting on the wedge shaped contact body acts between the contact body and a fixed part of the structure of the apparatus, it is alterntively possible for such resilient force providing means, e.g. a spring, to act between two oppositely acting contact bodies respectively cooling adjacent semiconductor devices, e.g. in an arrangement similar to that shown in JP-A-62106699, but employing line contact in the manner of the invention between the contact body and the inclined plane of surfaces on the semiconductor devices.

## Claims

1. Heat transfer system comprising:

a) a first body (10;102) having a planar first surface (15);

b) a second body (3) having a second surface (14,14a) spaced from said first surface;

c) a contact body (4) of heat conductive material contacting both said first and second surfaces (15,14,14a) to transfer heat by conduction from one of said first and second bodies to the other, said contact body (4) having a planar third surface (6) contacting said first surface (15) face-to-face and a fourth surface (5,5a) contacting said second surface (14,14a);

d) means (8) providing a force acting resiliently upon said contact body (4) in a predetermined direction so as to urge said contact body in a wedge-type action against both said first surface (15) and said second surface (14);

wherein one (14,14a) of said second and said fourth surfaces is a planar surface at an angle $\alpha$ to said first surface (15) and the other (5,5a) thereof is a convexly curved surface curving in one plane, said second surface and said fourth surface making line contact, said contact body (4) being free to move so as to maintain said face-to-face contact and said line contact, in order to accommodate varying relative positioning of said first and second bodies (10;102,3);

characterized in that said predetermined direction of action of said force-providing means (8) is at an angle $\beta$ to said first surface (15) given by $0 < \beta < (\alpha + 5)$, wherein $\alpha$ and $\beta$ are expressed in degrees.

2. Heat transfer system according to claim 1, wherein said force-providing means (8) attaches said contact body (4) to said second body (3).

3. Heat transfer system according to claim 1 or claim 2, wherein said curved surface is said fourth surface (5,5a).

4. Apparatus according to any one of claims 1 to 3 wherein $20 < \alpha < 70$.

5. Apparatus according to claim 4 wherein $30 < \alpha < 45$.

6. Apparatus according to any one of claims 1

to 5 wherein $\beta < (\alpha + 2)$.

7. Apparatus according to any one of claims 1 to 6 wherein $\beta > \alpha/2$.

8. Apparatus according to any one of claims 1 to 7 wherein said contact body (4) is of ceramic material.

9. Apparatus according to any one of claims 1 to 8 wherein said force providing means (8) is a mechanical spring.

10. Apparatus according to any one of claims 1 to 9 wherein said curved surface (5,5a) is a cylindrical surface, a surface of parabolic section or a surface approximating to a surface of parabolic section.

11. Heat transfer system according to any one of claims 1 to 10 for cooling at least one heat-generating device (10) selected from semiconductor devices and superconducting devices, wherein

a) said planar first surface (15) is either a surface of said heat-generating device or a surface in thermal connection with said heat-generating device;

b) said second surface (14,14a) spaced from said first surface is provided by cooling means (1,3) and is in thermal connection with at least one passage (1) in said cooling means for flow of a coolant.

12. Apparatus according to claim 11 wherein said cooling means comprises a housing (3) hermetically enclosing said heat-generating device (10) and said contact body (4), there being a helium atmosphere also enclosed in said housing (3) and surrounding at least said contact body (4).

13. Semiconductor apparatus having a plurality of semiconductor devices (10) mounted on a common base and a cooling system for said devices, said cooling system comprising:

a) cooling means (1,3) having at least one flow passage (1) for coolant;

b) a plurality of heat transfer systems one for each of said semiconductor devices (10) thermally connecting said devices to said cooling means for cooling by said coolant, each of said heat transfer systems being according to any one of claims 1 to 10 in which a first surface (15) is a surface of said semiconductor device (10) or a surface in thermal connection therewith and said second surface (14,14a) is a planar surface of said cooling means (3) in thermal connection with said coolant passage (1).

14. Apparatus according to claim 13 wherein said cooling means (3) comprises a common housing hermetically enclosing said semiconductor devices (10) and said contact bodies (4) said second surfaces (14; 14a) being surfaces of concavities on the inner face of the housing.

FIG. 1

FIG. 2

## FIG. 3

## FIG. 4

## FIG. 5

## FIG. 6

FIG. 7